# EUROPÄISCHE PATENTANMELDUNG

(11) **EP 4 779 864 A1**
(43) Veröffentlichungstag der Anmeldung: **22.07.2026**
(21) Anmeldenummer: 25153191.9
(22) Anmeldetag: 21.01.2025
(51) Int. Cl.: H02S 20/26, H02S 40/34, H02S 40/36, H10F 19/80

(54) **HALBZEUG MIT EINEM EIN FUNKTIONSELEMENT AUFWEISENDEN AKTIVEN BEGRENZUNGSELEMENT**

(71) Anmelder: voestalpine Stahl GmbH, 4020 Linz (AT)
(72) Erfinder: Kurz, Hannes, 4310 Mauthausen (AT); Geymayer, Lukas, 4040 Linz (AT); Kitzberger, Gregor, 4174 Niederwaldkirchen (AT)
(74) Vertreter: Hübscher & Partner Patentanwälte GmbH

(57) **Zusammenfassung**

Die Erfindung betrifft ein Halbzeug mit einem ein Funktionselement (1) aufweisenden aktiven Begrenzungselement (2), sowie auf ein aus diesem Halbzeug gefertigtes Bauteil und ein entsprechendes Herstellungsverfahren. Um ein dämmendes Bauteil bei hohen Produktionsgeschwindigkeiten mit einem integrierten Funktionselement (1) so fertigen zu können, dass die Anschlusskomponenten (4, 5) während der Herstellung insbesondere gegenüber dem Dämmmaterial (18) geschützt sind und dennoch der Anschluss (4) des Funktionselements (1) während der Montage besser zugänglich ist wird vorgeschlagen, dass bei dem Halbzeug das aktive Begrenzungselement (2) einen nach außen geführten Anschluss (4) für das Funktionselement (1) aufweist, wobei ein einen Anschlussbereich (8) bildendes Abgrenzelement (6) mit einem Schutzabschnitt (9) im Bereich des Anschlusses (4) an das aktive Begrenzungselement (2) angesetzt ist und mit einem Trennabschnitt (10) wenigstens teilweise über eine Stoßfläche (11) des aktiven Begrenzungselements (2) hinausragt.

## Beschreibung

Die Erfindung bezieht sich auf ein Halbzeug mit einem ein Funktionselement aufweisenden aktiven Begrenzungselement, sowie auf ein aus diesem Halbzeug gefertigtes Bauteil und ein entsprechendes Herstellungsverfahren.

Die EP2871299B1 offenbart ein Bauteil mit zwei einander gegenüberliegenden Metalltafeln als Begrenzungselemente, welche einen Zwischenraum bilden, der ein PV-Modul als Funktionselement einfasst und zur Vermeidung eines Wärmeübergangs mit einem geschäumten Dämmmaterial verfüllt ist. Das PV-Modul ist dabei innerhalb des Zwischenraums angeordnet und absorbiert durch eine Öffnung im unmittelbar angrenzenden Begrenzungselement einfallendes Licht. Im anderen Begrenzungselement befindet sich eine Anschlussdose, mit welcher das PV-Modul durch das Dämmmaterial hindurch kontaktiert ist. Die Anschlussleitungen werden während der Herstellung durch den Zwischenraum hindurch verlegt und mit dem Dämmmaterial mit verschäumt.

Nachteilig an dieser Anordnung ist, dass das Dämmmaterial mit den Anschlussleitungen sowie deren Kontaktstellen in Berührung kommt, was eine entsprechende Beständigkeit der Anschlusskomponenten gegenüber dem Dämmmaterial erfordert. Zudem ist die auf der Rückseite des Bauteils liegende Anschlussdose während der Montage nicht mehr ohne weiteres zugänglich. Schließlich macht der geoffenbarte Aufbau eine diskontinuierliche Fertigung erforderlich, was einen entsprechend langsamen Produktionsprozess bedingt.

Der Erfindung liegt somit die Aufgabe zugrunde, ein Halbzeug zur Verfügung zu stellen, aus welchem bei hohen Produktionsgeschwindigkeiten ein dämmendes Bauteil mit einem integrierten Funktionselement so gefertigt werden kann, dass die Anschlusskomponenten während der Herstellung insbesondere gegenüber dem Dämmmaterial geschützt sind und dennoch der Anschluss des Funktionselements während der Montage besser zugänglich ist.

Die Erfindung löst die gestellte Aufgabe dadurch, dass bei dem Halbzeug der eingangs geschilderten Art das aktive Begrenzungselement einen nach außen geführten Anschluss für das Funktionselement aufweist, wobei ein einen Anschlussbereich bildendes Abgrenzelement mit einem Schutzabschnitt im Bereich des Anschlusses an das aktive Begrenzungselement angesetzt ist und mit einem Trennabschnitt wenigstens teilweise über eine Stoßfläche des aktiven Begrenzungselements hinausragt.

Zur Folge dieser Merkmale hält das Abgrenzelement mit seinem Schutzabschnitt den Anschluss frei von Dämmmaterial, ragt mit seinem Trennabschnitt über die Stoßfläche des aktiven Begrenzungselements hinaus, womit der Anschluss von der Stoßfläche aus zugänglich gemacht werden kann und bildet einen Anschlussbereich, der eine Durchführung von Anschlussleitungen durch das Dämmmaterial obsolet macht. Das Abgrenzelement bildet eine Barriere für das Dämmmaterial, das nach der Herstellung sowohl am Begrenzungselement als auch am Abgrenzelement anliegt und somit nicht in den Anschlussbereich eindringen kann. Das Dämmmaterial kann beispielsweise ein flüssig einbringbarer, polymerisierender Schaum, wie beispielsweise PUR- oder PIR-Schaum sein oder Mineralwolle. Nachdem das Abgrenzelement seine Funktion als Barriere für das Dämmmaterial erfüllt hat, kann es im Bereich des Trennabschnitts durchtrennt und somit auf die Dimensionen des aktiven Begrenzungselements gekürzt werden. Das Abgrenzelement wird somit wenigstens um einen Teil des Trennabschnitts gekürzt, sodass der Anschluss von der Stoßfläche aus einfacher zugänglich wird. Das aktive Begrenzungselement kann einen Träger aus Metall aufweisen, insbesondere aus Stahl. Das Funktionselement kann insbesondere eine photovoltaische Beschichtung sein. In einer bevorzugten Ausführungsform ist der Träger eine Stahltafel und das Funktionselement eine auf dem Träger aufgebrachte PV-aktive Beschichtung. Das Abgrenzelement kann eine Klebefläche aufweisen, über welche es mit dem aktiven Begrenzungselement verbunden ist. Beispielsweise kann das Abgrenzelement ein Hutprofil aufweisen. Damit eine Verformung des Abgrenzelements beim Trennen und damit die Gefahr der Ausbildung eines Spalts zwischen dem Dämmmaterial und dem Abgrenzelement, sowie eines Eintritts von Dämmmaterial in den Anschlussbereich vermieden wird, können im Bereich des Trennabschnitts Versteifungsrippen vorgesehen sein.

Werden die Träger in einem kontinuierlichen Fertigungsverfahren, beispielsweise aus einem Band gefertigt, ergibt sich die Schwierigkeit, dass entweder bereits die Funktionselemente diskontinuierlich aufgebracht werden müssen oder nach dem Aufbringen nur mehr eine geringe Biegetoleranz aufweisen, sodass eine kontinuierliche Weiterverarbeitung nicht mehr ohne weiteres möglich ist, da beispielsweise ein Aufwickeln entfallen muss. Um eine kontinuierliche Weiterverarbeitung dennoch zu ermöglichen, können die Halbzeuge in einer Förderrichtung aufeinanderfolgend angeordnet werden, wobei das Abgrenzelement einen Ausrichtungsanschlag für ein weiteres Halbzeug ausbildet. Um die gemeinsame Förderung der Halbzeuge in einer Verarbeitungslinie zu verbessern, kann das Abgrenzelement einen über die Stoßfläche hinausragenden Verbindungsabschnitt zur Befestigung an einem weiteren Halbzeug, insbesondere an dessen aktivem Begrenzungselement, aufweisen. Der Verbindungsabschnitt kann auf der dem Schutzabschnitt gegenüberliegenden Seite des Trennabschnitts anschließen, sodass beim Abtrennen des Abgrenzelements die Befestigung wieder gelöst wird. Die Befestigung kann insbesondere zugfest und/oder formschlüssig sein und kann beispielsweise über einen Haken oder eine Klebefläche gebildet sein.

Da einige Funktionselemente auf der freibleibenden Außenseite des Halbzeuges angeordnet werden müssen, der Anschluss dieser Funktionselemente aber vor witterungsbedingten Beschädigungen geschützt werden muss, wird vorgeschlagen, dass das Funktionselement auf einem Träger angeordnet und durch den Träger hindurch mit dem Anschluss verbunden ist. Dadurch kann das an der Außenseite liegende Funktionselement über die gegenüberliegende Innenseite angeschlossen werden, wobei der Anschluss nicht nur vor Witterungseinflüssen geschützt wird, sondern auch eine Beschädigung durch das innenliegende Dämmmaterial aufgrund der erfindungsgemäßen Maßnahmen vermieden wird.

Um eine Beschädigung oder Verunreinigung der Anschlusskomponenten im Rahmen des Herstellungsverfahrens zu vermeiden, kann zwischen Schutzabschnitt und Trennabschnitt ein Schutzelement für den Anschluss und/oder eine mit dem Anschluss verbundene Anschlussleitung vorgesehen sein, wobei die Anschlusskomponenten den Anschluss und die Anschlussleitung umfassen. Die Anschlussleitung ermöglicht die Verbindung des Anschlusses zum Zeitpunkt der Herstellung, zu dem der Anschluss noch frei zugänglich ist, sodass der Querschnitt des Anschlussbereichs entsprechend klein dimensioniert werden kann. Einerseits verhindert das Schutzelement, dass Verunreinigungen in den Schutzabschnitt gelangen können, andererseits kann das Schutzelement die Anschlusskomponenten im Schutzabschnitt rückhalten, sodass diese nicht in den Trennabschnitt gelangen, wo diese beim Abtrennen des Abgrenzelements beschädigt oder gar durchtrennt werden könnten. Vorteilhafterweise ist das Schutzelement über eine Sollbruchstelle mit dem Abgrenzelement verbunden. Nach dem Abtrennen des Abgrenzelements kann, gegebenenfalls nach Entfernung des Schutzelements, die Anschlussleitung stoßseitig aus dem Anschlussbereich herausgeführt werden. Das Schutzelement kann auch als den Querschnitt des Anschlussbereichs verengende Blende ausgebildet sein. Dies hat den Vorteil, dass das Schutzelement nach der Herstellung nicht notwendigerweise entfernt werden muss, die Blende während der Herstellung aber dennoch einen Anschlag für die Anschlussleitung bildet.

Damit das Halbzeug in einem späteren Herstellungsverfahren auf einfache Weise manipuliert oder mit einem weiteren Begrenzungselement verbunden werden kann, ohne das Funktionselement oder den Anschluss zu beschädigen, können das Funktionselement und der Anschluss außerhalb der sich zwischen den beiden Stoßflächen erstreckenden Randbereiche angeordnet sein. Dies bedeutet, dass sich die beiden Stoßflächen gegenüberliegen und gemeinsam mit zwei sich ebenfalls gegenüberliegenden Seitenflächen das Halbzeug begrenzen, wobei die Randbereiche entlang der Seitenflächen verlaufen. Dadurch kann im Randbereich ein Fördermittel an das Halbzeug angreifen und/oder ein weiteres Begrenzungselement, beispielsweise durch Umformen oder Schweißen mit dem Halbzeug verbunden werden.

Obwohl das Abgrenzelement stoßseitig offenbleiben kann, wenn der Trennabschnitt aus dem mit dem Dämmmaterial verfüllten Zwischenraum herausragt, empfiehlt es sich für eine verkürzte Bauweise und eine kontinuierliche Einbringung des Dämmmaterials, dass das Abgrenzelement ausschließlich zum aktiven Begrenzungselement hin offen ausgebildet ist. Dadurch wird ein Eindringen von Dämmmaterial in den Anschlussbereich unabhängig von der Art des Dämmmaterials besonders zuverlässig verhindert. Durch das Abtrennen des Abgrenzelements im Bereich des Trennabschnitts, insbesondere parallel zur Stoßfläche des Begrenzungselements, kann der Anschluss nach dem Verfüllen mit Dämmmaterial von der Stoßfläche aus zugänglich gemacht werden.

Ein aus einem erfindungsgemäßen Halbzeug hergestelltes dämmendes Bauteil, das einen während der Montage leicht zugänglichen und dennoch geschützten Anschlussbereich bereitstellt, weist zwei bezüglich eines Zwischenraums einander gegenüberliegende Begrenzungselemente auf, wobei eines der Begrenzungselemente ein Funktionselement aufweist, das mit einem auf der dem Zwischenraum zugewandten Innenseite liegenden Anschluss verbunden ist, wobei der Zwischenraum einen verfüllten Dämmbereich und einen über ein Abgrenzelement vom Dämmbereich abgegrenzten Anschlussbereich umfasst und das Abgrenzelement einen Schutzabschnitt für den Anschluss und einen zu einer Stoßfläche hin offenen Trennabschnitt aufweist.

Zur Folge dieser Ausgestaltung können die dämmenden Bauteile während der Montage über den stoßseitig zugänglichen Anschlussbereich verbunden werden, während die Witterungseinflüssen ausgesetzte Außenseite frei von Anschlusskomponenten bleibt. Der Anschluss des Funktionselements kommt an der Innenseite des aktiven Begrenzungselements zu liegen und wird dort durch den vom Abgrenzelement gebildeten Anschlussbereich vor eindringendem Dämmmaterial geschützt. Das Abgrenzelement bildet einen Anschlussbereich, der nach dem Durchtrennen des Trennabschnitts zur Stoßfläche hin zugänglich ausgebildet ist, sodass der Anschluss auf einfache Weise mit Gebäudeinfrastrukturanschlüssen oder mit weiteren Bauteilen zu einem Bauwerk verbunden werden kann. Insbesondere kann das Bauteil ein Fassadenelement bilden, das mit anderen Bauteilen zu einer Fassade zusammengesetzt ist. Sollen die Anschlusskomponenten bis kurz vor der Montage geschützt bleiben, kann das Bauteil zwischen dem Schutzabschnitt und dem Trennabschnitt ein Schutzelement gemäß dem beschriebenen Halbzeug aufweisen, die bevorzugt den Schutzabschnitt während der Fertigung und des Transports verschließt. Die Begrenzungselemente können einen Träger aus Metall aufweisen, insbesondere aus Stahl. Wie bereits in Bezug auf das Halbzeug ausgeführt wurde, kann das Funktionselement insbesondere eine photovoltaische Beschichtung sein. In einer bevorzugten Ausführungsform sind die Träger Stahltafeln und das Funktionselement eine auf einem der Träger aufgebrachte PV-aktive Beschichtung. Die beiden Begrenzungselemente können entlang der sich zwischen den beiden gegenüberliegenden Stoßflächen erstreckenden Randbereiche miteinander verbunden sein. Deshalb empfiehlt es sich, dass das Funktionselement und der Anschluss außerhalb der sich zwischen den beiden Stoßflächen erstreckenden Randbereiche angeordnet sind. Für das Abgrenzelement gelten dieselben bevorzugten Ausführungen, wie für das erfindungsgemäße Halbzeug.

Da einige Funktionselemente auf der Außenseite des Bauteils angeordnet werden müssen, der Anschluss dieser Funktionselemente aber vor witterungsbedingten Beschädigungen geschützt werden muss, wird vorgeschlagen, dass das Funktionselement auf einem Träger angeordnet und durch den Träger hindurch mit dem Anschluss verbunden ist. Dadurch kann das an der Außenseite liegende Funktionselement über die gegenüberliegende Innenseite angeschlossen werden, wobei der Anschluss nicht nur vor Witterungseinflüssen geschützt wird, sondern auch eine Beschädigung durch das innenliegende Dämmmaterial aufgrund der erfindungsgemäßen Maßnahmen vermieden wird.

Um aus einem erfindungsgemäßen Halbzeug bei hohen Produktionsgeschwindigkeiten ein erfindungsgemäßes Bauteil herzustellen, wobei die Funktionselemente und/oder die Anschlusskomponenten vor Beschädigungen geschützt werden, wird vorgeschlagen, dass ein Halbzeug und ein auf der Seite des Abgrenzelements des Halbzeuges liegendes weiteres Begrenzungselement unter Ausbildung eines Zwischenraums angeordnet werden, wobei der Zwischenraum mit einem Dämmmaterial verfüllt wird, wonach das Abgrenzelement im Bereich seines Trennabschnittes getrennt wird.

Dadurch wird beim Verfüllen des Zwischenraums mit Dämmmaterial der Anschluss durch das Abgrenzelement geschützt und es ist keine Verlegung von Anschlussleitungen mehr während der Herstellung nötig. Nach dem Verfüllen des Zwischenraums wird der über die Stoßfläche des aktiven Begrenzungselements hinausragende Teil des Abgrenzelements im Bereich des Trennabschnitts getrennt und dadurch das Bauteil auf die gewünschten Dimensionen, insbesondere auf die Dimensionen des aktiven Begrenzungselements gekürzt. Nach dem Trennen kann gegebenenfalls ein zwischen dem Schutzabschnitt und dem Trennabschnitt vorgesehenes Schutzelement für eine Anschlussleitung entfernt werden, sodass der Anschlussbereich des Bauteils stoßseitig freigelegt wird und die Anschlussleitung herausgeführt werden kann.

Grundsätzlich kann ein Dämmmaterial so gewählt werden, dass die beiden Begrenzungselemente am Dämmmaterial haften bleiben. Ist dies nicht der Fall, oder reicht die Haftung nicht aus, so kann das Halbzeug mit dem weiteren Begrenzungselement nach dem Verfüllen des Zwischenraums verbunden werden. Die Verbindung erfolgt bevorzugt an den sich zwischen den beiden Stoßflächen erstreckenden Randbereichen durch insbesondere Schweißen oder Kleben.

Um eine für das Dämmmaterial auslaufsichere Aufnahme zu bilden und/oder die nachfolgende Verbindung mit dem weiteren Begrenzungselement zu erleichtern, können die sich zwischen den beiden Stoßflächen erstreckenden Randbereiche der Halbzeuge vor dem Verfüllen des Zwischenraums umgeformt werden. Hierfür eignen sich Verfahren wie ein Rollformen, Umbördeln, Tiefziehen, Schwenkbiegen oder Abkantpressen.

Um die Bauteile besonders schnell und dennoch mit hoher Ausrichtungsgenauigkeit der Halbzeuge herstellen zu können, können mehrere Halbzeuge in einer Förderrichtung aufeinanderfolgend angeordnet werden, wobei jeweils das Abgrenzelement eines Halbzeuges die angrenzende Stoßfläche eines benachbarten Halbzeuges überragt. Das Abgrenzelement bildet hierbei einen Ausrichtungsanschlag für ein weiteres Halbzeug aus und die Halbzeuge können in einem kontinuierlichen Herstellungsverfahren auf einer Förderlinie transportiert werden. In diesem Fall wird das weitere Begrenzungselement bevorzugt kontinuierlich auf der Seite der Abgrenzelemente der Halbzeuge zugeführt, um den Zwischenraum auszubilden. Der Zwischenraum kann ebenfalls kontinuierlich mit Dämmmaterial verfüllt werden, wobei das Dämmmaterial insbesondere als Schaum in den Zwischenraum injiziert wird. Bei einem solchen kontinuierlichen Herstellungsverfahren entsteht ein Endlosverbund, welcher durch das Trennen des Abgrenzelements im Bereich seines Trennabschnittes vorzugsweise quer zur Förderrichtung in einzelne Bauteile getrennt wird. Beim Trennen werden insbesondere auch das Dämmmaterial und/oder das weitere Begrenzungselement mitgetrennt, um eine plane Stoßfläche zu erhalten.

Um Übergangsprobleme zwischen mehreren aufeinanderfolgenden Halbzeugen in einem kontinuierlichen Herstellungsprozess zu vermeiden, die Ausrichtungsgenauigkeit noch weiter zu erhöhen und die Förderung zu erleichtern, kann der Verbindungsabschnitt des Abgrenzelements eines Halbzeuges mit dem angrenzenden Halbzeug zugfest verbunden werden. Im Falle einer spaltfreien Verbindung zwischen zwei aufeinanderfolgenden Halbzeugen, sodass diese eine durchgängige Aufnahmefläche für das Dämmmaterial bilden, kann der Zwischenraum in einem kontinuierlichen Prozess besonders prozessrein verfüllt werden. Um einen im angrenzenden Halbzeug zurückbleienden Verbindungsabschnitt zu entfernen, der dort eine Verminderung der Dämmwirkung verursachen könnte, kann der Endlosverbund zusätzlich in Förderrichtung hinter dem Verbindungsabschnitt durchtrennt werden.

Um das kontinuierliche Herstellungsverfahren noch weiter zu beschleunigen und zu vereinfachen kann das weitere Begrenzungselement ein mehrere Halbzeuge überspannendes Begrenzungsband sein, das gemeinsam mit dem Abgrenzelement getrennt wird. Das Begrenzungsband wird auf der Seite der Abgrenzelemente der Halbzeuge zugeführt, um den Zwischenraum auszubilden. Beim Trennen des Abgrenzelements wird insbesondere auch das Dämmmaterial getrennt. Das Begrenzungsband ist insbesondere ein Stahlband.

Um die erfindungsgemäßen Bauteile in Form eines Bauwerks, welches beispielsweise eine Fassadenverkleidung ist, zu montieren, werden bei der Montage mehrere nebeneinander angeordneten Bauteile über die stoßseitig offenen Anschlussbereiche miteinander verbunden. Es sind keine Überlappungen der Bauteile nötig, um die Anschlusskomponenten zu schützen und die Anschlüsse können auf einfache Weise verbunden, gewartet und repariert werden.

In der Zeichnung ist der Erfindungsgegenstand beispielsweise dargestellt. Es zeigen
- Fig. 1: einen schematischen Querschnitt durch ein erfindungsgemäßes Halbzeug,
- Fig. 2: eine schematische Aufsicht auf das Halbzeug der Fig. 1,
- Fig. 3: einen schematischen Querschnitt durch ein erfindungsgemäßes Bauteil und
- Fig. 4: einen schematischen Ablauf eines kontinuierlichen Verfahrens zur Herstellung eines erfindungsgemäßen Bauteils.

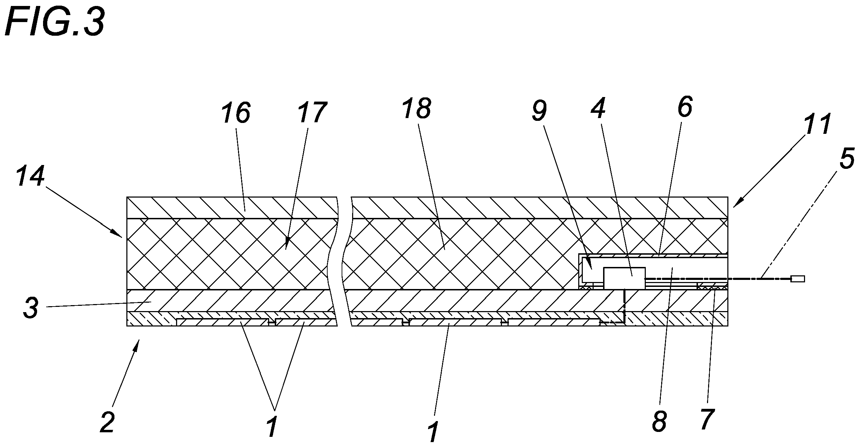

Ein erfindungsgemäßes Halbzeug weist ein mit einem Funktionselement 1 versehenes aktives Begrenzungselement 2 auf. Das aktive Begrenzungselement 2 umfasst einen Träger 3, beispielsweise eine Stahltafel, auf welchem das Funktionselement 1 als Beschichtung aufgebracht ist. Das Funktionselement 1 ist durch den Träger 3 hindurch mit einem Anschluss 4 verbunden, der beispielsweise über eine Anschlussleitung 5 nach außen geführt sein kann, wie dies insbesondere der Fig. 3 entnommen werden kann. Ein Abgrenzelement 6 ist über eine Klebefläche 7 mit dem aktiven Begrenzungselement 2 verbunden und bildet einen Anschlussbereich 8. Das Abgrenzelement 6 umgibt den Anschluss 4 mit einem Schutzabschnitt 9 und ragt teilweise mit einem Trennabschnitt 10 über eine Stoßfläche 11 des aktiven Begrenzungselements 2 hinaus. Das Abgrenzelement 6 weist weiters einen über die Stoßfläche 11 des aktiven Begrenzungselements 2 hinausragenden Verbindungsabschnitt 12 auf, welcher zur Befestigung mit einem weiteren Begrenzungselement 2 dienen kann. Zwischen dem Schutzabschnitt 9 und dem Trennabschnitt 10 befindet sich ein Schutzelement 13 für den Anschluss 4 und die Anschlussleitung 5, sodass die Anschlusskomponenten während des Herstellungsverfahrens geschützt sind und nicht in den Trennabschnitt 10 gelangen können. Das gezeigte Abgrenzelement 6 ist lediglich zum aktiven Begrenzungselement 2 hin offen ausgebildet und stoßseitig geschlossen.

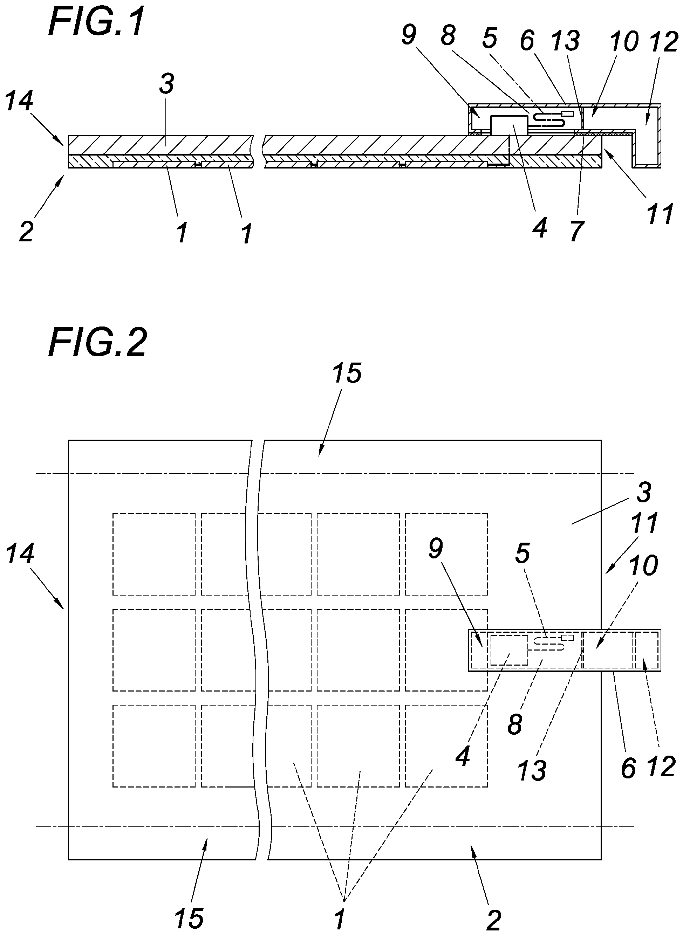

Wie insbesondere der Fig. 2 entnommen werden kann, sind das Funktionselement 1 und der Anschluss 4 außerhalb der sich zwischen den beiden Stoßflächen 11, 14 erstreckenden Randbereiche 15 angeordnet. Der Anschluss 4 und die Anschlussleitung 5 befinden sich innerhalb des Abgrenzelements 6 und sind dadurch von diesem geschützt.

Fig. 3 zeigt in einem schematischen Querschnitt durch ein erfindungsgemäßes Bauteil mit zwei einander gegenüberliegenden Begrenzungselementen 2, 16, wobei das untere Begrenzungselement 2 aktiv ausgebildet ist und Funktionselemente 1 aufweist, die auf einen Träger 3 aufgebracht sind. Die beiden Begrenzungselemente 2, 16 fassen einen Zwischenraum 17 mit einem verfüllten Dämmbereich 18 ein, der durch das Abgrenzelement 6 vom Anschlussbereich 8 getrennt ist. Der Anschluss 4 kommt innerhalb dieses Anschlussbereichs 8, an der dem Zwischenraum 17 zugewandten Innenseite 19 des aktiven Begrenzungselements 2 zu liegen. Der Schutzabschnitt 9 mündet in einen zu einer Stoßfläche 11 hin offenen Trennabschnitt 10, durch welchen eine Anschlussleitung 5 herausgeführt ist. Alle anderen Anschlusskomponenten befinden sich im Inneren des Bauteils und sind somit vor Witterungseinflüssen geschützt.

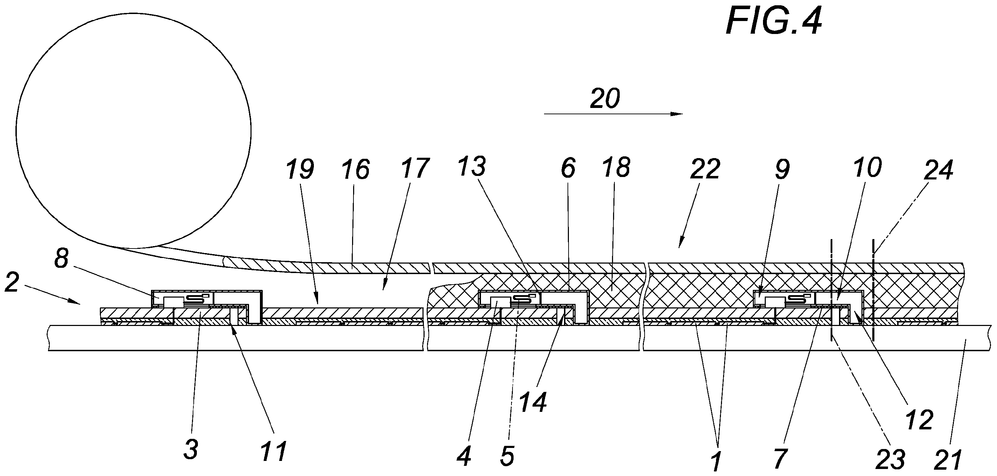

In Fig. 4 ist ein schematischer Ablauf eines kontinuierlichen Herstellungsverfahrens für ein erfindungsgemäßes Bauteil gezeigt. Mehrere Halbzeuge der Fig. 1 werden in einer Förderrichtung 20 aufeinanderfolgend auf einer Förderlinie 21 angeordnet, wobei jeweils ein Abgrenzelement 6 eines Halbzeuges eine angrenzende Stoßfläche 14 eines benachbarten Halbzeugs überragt. In der gezeigten Abbildung ist ein Verbindungsabschnitt 12 des Abgrenzelements 6 mit einem angrenzenden Halbzeug verbunden. Ein weiteres Begrenzungselement 16 ist als Begrenzungsband ausgeführt und wird kontinuierlich auf der Seite der Abgrenzelemente 6 der Halbzeuge zugeführt, um einen Zwischenraum 17 auszubilden. Der entstehende Zwischenraum 17 wird kontinuierlich mit einem Dämmmaterial 18 verfüllt, wobei das Abgrenzelement 6 einen Anschlussbereich 8 bildet und somit alle Anschlusskomponenten 4, 5 vor Dämmmaterial 18 schützt. Es entsteht somit ein Endlosverbund 22. Nach dem Verfüllen des Zwischenraums 17 wird der über die Stoßfläche 11 eines Halbzeugs hinausragende Teil des Abgrenzelements 6 durch einen Schnitt 23 durch den Trennabschnitt 10 auf die gewünschte Dimension gekürzt, wobei auch das Dämmmaterial 18 und die beiden Begrenzungselemente 2, 16 mitgekürzt werden, um eine plane Stoßfläche 11 zu bilden. Nach dem Kürzen kann gegebenenfalls eine Rückhalteeinrichtung 13 entfernt werden, um den Anschlussbereich 8 des Bauteils stoßseitig freizulegen und eine Anschlussleitung 5 herausführen zu können. Zusätzlich wird der Endlosverbund 22 in Förderrichtung 20 hinter dem Verbindungsabschnitt 12 in einem Schnitt 24 durchtrennt, sodass der Verbindungsabschnitt 12 nicht im Bauteil verbleibt.

## Patentansprüche

1. Halbzeug mit einem ein Funktionselement (1) aufweisenden aktiven Begrenzungselement (2), **dadurch gekennzeichnet, dass** das aktive Begrenzungselement (2) einen nach außen geführten Anschluss (4) für das Funktionselement (1) aufweist, wobei ein einen Anschlussbereich (8) bildendes Abgrenzelement (6) mit einem Schutzabschnitt (9) im Bereich des Anschlusses (4) an das aktive Begrenzungselement (2) angesetzt ist und mit einem Trennabschnitt (10) wenigstens teilweise über eine Stoßfläche (11) des aktiven Begrenzungselements (2) hinausragt.

2. Halbzeug nach Anspruch 1, **dadurch gekennzeichnet, dass** das Abgrenzelement (6) einen über die Stoßfläche (11) hinausragenden Verbindungsabschnitt (12) zur Befestigung an einem weiteren aktiven Begrenzungselement (2) aufweist.

3. Halbzeug nach einem der Ansprüche 1 oder 2, **dadurch gekennzeichnet, dass** das Funktionselement (1) auf einem Träger (3) angeordnet und durch den Träger (3) hindurch mit dem Anschluss (4) verbunden ist.

4. Halbzeug nach einem der Ansprüche 1 bis 3, **dadurch gekennzeichnet, dass** zwischen Schutzabschnitt (9) und Trennabschnitt (10) ein Schutzelement (13) für den Anschluss (4) und/oder eine mit dem Anschluss (4) verbundene Anschlussleitung (5) vorgesehen ist.

5. Halbzeug nach einem der Ansprüche 1 bis 4, **dadurch gekennzeichnet, dass** das Funktionselement (1) und der Anschluss (4) außerhalb der sich zwischen den beiden Stoßflächen (11, 14) erstreckenden Randbereiche (15) angeordnet sind.

6. Halbzeug nach einem der Ansprüche 1 bis 5, **dadurch gekennzeichnet, dass** das Abgrenzelement (6) ausschließlich zum aktiven Begrenzungselement (2) hin offen ausgebildet ist.

7. Bauteil mit zwei bezüglich eines Zwischenraums (17) einander gegenüberliegenden Begrenzungselementen (2, 16), wobei eines der Begrenzungselemente (2) ein Funktionselement (1) aufweist, das mit einem auf der dem Zwischenraum (17) zugewandten Innenseite (19) liegenden Anschluss (4) verbunden ist, wobei der Zwischenraum (17) einen verfüllten Dämmbereich (18) und einen über ein Abgrenzelement (6) vom Dämmbereich (18) abgegrenzten Anschlussbereich (8) umfasst, **dadurch gekennzeichnet, dass** das Abgrenzelement (6) einen Schutzabschnitt (9) für den Anschluss (4) und einen zu einer Stoßfläche (11) hin offenen Trennabschnitt (10) aufweist.

8. Bauteil nach Anspruch 7, **dadurch gekennzeichnet, dass** das Funktionselement (1) auf einem Träger (3) angeordnet und durch den Träger (3) hindurch mit dem Anschluss (4) verbunden ist.

9. Verfahren zum Herstellen eines Bauteils aus einem Halbzeug nach einem der Ansprüche 1 bis 5, **dadurch gekennzeichnet, dass** ein Halbzeug und ein auf der Seite des Abgrenzelements (6) des Halbzeuges liegendes weiteres Begrenzungselement (16) unter Ausbildung eines Zwischenraums (17) angeordnet werden, wobei der Zwischenraum (17) mit einem Dämmmaterial (18) verfüllt wird, wonach das Abgrenzelement (6) im Bereich seines Trennabschnittes (10) getrennt wird.

10. Verfahren nach Anspruch 9, **dadurch gekennzeichnet, dass** das Halbzeug mit dem weiteren Begrenzungselement (16) nach dem Verfüllen des Zwischenraums (17) verbunden wird.

11. Verfahren nach Anspruch 9 oder 10, **dadurch gekennzeichnet, dass** die sich zwischen den beiden Stoßflächen (11, 14) erstreckenden Randbereiche (15) der Halbzeuge vor dem Verfüllen des Zwischenraums (17) umgeformt werden.

12. Verfahren nach einem der Ansprüche 9 bis 11, **dadurch gekennzeichnet, dass** mehrere Halbzeuge in einer Förderrichtung (20) aufeinanderfolgend angeordnet werden, wobei jeweils das Abgrenzelement (6) eines Halbzeuges die angrenzende Stoßfläche (14) eines benachbarten Halbzeuges überragt.

13. Verfahren nach Anspruch 12, **dadurch gekennzeichnet, dass** der Verbindungsabschnitt (12) des Abgrenzelements (6) eines Halbzeuges mit dem angrenzenden Halbzeug zugfest verbunden wird.

14. Verfahren nach Anspruch 12 oder 13, **dadurch gekennzeichnet, dass** das weitere Begrenzungselement (16) ein mehrere Halbzeuge überspannendes Begrenzungsband ist, das gemeinsam mit dem Abgrenzelement (6) getrennt wird.

15. Bauwerk aus mehreren nebeneinander angeordneten Bauteilen nach einem der Ansprüche 7 oder 8, **dadurch gekennzeichnet, dass** die Bauteile über die stoßseitig offenen Anschlussbereiche (8) miteinander verbunden sind.
